# FASCICULE DE BREVET EUROPEEN

(11) **EP 0 476 774 B1**
(45) Date de publication et mention de la délivrance du brevet: **12.04.1995**
(21) Numéro de dépôt: 91202373.6
(22) Date de dépôt: 17.09.1991
(51) Int. Cl.: C30B 25/14, C30B 31/16

(54) **Chambre ayant une zone chaude et une zone froide et au moins une tubulure d'introduction de gaz**
Kammer mit einer Warm- und einer Kaltzone und mindestens mit einem Gaszuführungsrohr
Chamber with a warm and a cold area and at least one gas inlet tube

(30) Priorité: 21.09.1990 FR 9011666
(43) Date de publication de la demande: 25.03.1992
(73) Titulaire: LABORATOIRES D'ELECTRONIQUE PHILIPS, 94450 Limeil-Brévannes (FR); Philips Electronics N.V., 5621 BA Eindhoven (NL)
(72) Inventeur: Foucher, Claude, F-75008 Paris (FR); Maluenda, José, F-75008 Paris (FR)
(74) Mandataire: Charpail, François

(56) Documents cités:
- EP-A- 0 247 680
- DE-C- 3 721 636
- US-A- 4 592 307

## Description

L'invention concerne une chambre ayant, considérée selon son axe longitudinal, une zone chaude et une zone froide, et ayant au moins une tubulure d'introduction de gaz.

L'invention concerne également une chambre de réacteur pour la réalisation de recuits de dispositifs semiconducteurs.

L'invention trouve son application particulièrement dans la réalisation de dispositifs semiconducteurs du groupe III-V.

Une chambre de réacteur, pour la réalisation de couches épitaxiales en phase vapeur est connue de la demande de brevet européen EP-247 680. Cette chambre possède, outre un porte-échantillon pour un substrat à traiter, un dispositif d'introduction des gaz directement dans la zone chaude de la chambre où est situé le porte-échantillon. Ce dispositif consiste en plusieurs tubes cylindriques concentriques, dont le plus interne débouche dans un (ou des) tubes intermédiaire(s) qui débouche(nt) lui-même (ou eux-mêmes) dans le tube le plus externe. Ce dernier débouche alors à proximité d'un substrat à traiter.

Le document cité traite uniquement du problème de l'introduction des gaz en zone chaude pour un réacteur d'épitaxie en phase vapeur.

Or les problèmes liés à la croissance épitaxiale en phase vapeur sont particuliers. D'une part, le nombre d'échantillons traités à la fois est faible. Les chambres de réacteur sont donc d'un volume faible.

Les problèmes liés à la croissance épitaxiale ne sont pas les mêmes que les problèmes liés au recuit de plaquettes de matériaux semiconducteurs. Il faut d'abord savoir que lors de l'élaboration de circuits intégrés, interviennent des étapes, telles que celles d'implantations ioniques, qui doivent être suivies de recuits à des températures élevées.

Or certains matériaux semiconducteurs, parmi lesquels on peut citer les matériaux du groupe III-V subissent une altération de leur état de surface, par décomposition, lorsqu'ils sont portés aux températures nécessaires à effectuer ces opérations de recuits. Une solution à ce problème consiste à réaliser l'opération de recuit sous un flux d'un gaz prévenant l'altération de l'état de surface. Par exemple, pour effectuer des recuits de matériaux pour circuits intégrés sur arséniure de gallium, il est nécessaire de soumettre les échantillons à un flux d'arsenic. Ce flux est obtenu par cracking de l'arsine (AsH₃) à température élevée, dans la zone chaude de la chambre, en même temps que s'effectue le recuit.

Mais l'utilisation de gaz tels que l'arsine dans les opérations de recuit pose un certain nombre de problèmes résultant des propriétés de ces gaz.

Le principal problème réside dans le fait que des gaz obtenus ainsi par décomposition à haute température, se condensent ensuite dans les zones froides de la chambre sur les parois. De telles zones froides existent de part et d'autre de la zone chaude, à chaque extrémité de la chambre de recuit.

Si bien qu'à l'issue du recuit, lorsque le porte-échantillon est extrait de la chambre par translation, par exemple au moyen d'une canne, les échantillons passent nécessairement dans une zone froide à proximité des parois polluées par ces dépôts dus à la condensation.

On a ainsi fait l'expérience que des échantillons d'arséniure de gallium de 2 ou 3 pouces (environ 5 et 7,5 cm respectivement) de diamètre pouvait recevoir plus de 20000 poussières par échantillon.

Ces dépôts de poussières dus à la pollution des parois froides des chambres de recuit sont extrêmement gênants. En effet, ils modifient considérablement, à la baisse, les performances des circuits intégrés. Ils s'appliquent à des échantillons déjà longuement élaborés, donc dans un état de leur fabrication où ils ont atteint un niveau de coût non négligeable. Ils s'appliquent à de nombreux échantillons à la fois, car les recuits sont pratiqués par groupes d'une cinquantaine d'échantillons. Ils entraînent en outre une dispersion des performances des échantillons qui deviennent alors peu fiables.

De plus, ces dépôts persistent dans les chambres à la fin des opérations de recuits. Il est alors nécessaire d'opérer une décontamination des parois. Il s'avère que tant les échantillons que les parois contaminés sont un danger pour les manipulateurs qui sont ainsi amenés à inhaler involontairement des particules polluantes, lors du traitement ultérieur des échantillons ou lors de l'opération de décontamination des parois de la chambre. Or dans le cas de l'arsine par exemple, ces particules polluantes sont hautement toxiques.

En outre, l'opération de décontamination des parois de la chambre, entre chaque recuit, est longue et coûteuse en temps de fabrication.

On constate donc que les problèmes liés au recuit d'échantillons sous flux de gaz obtenus par la décomposition à température élevée de composés polluants capables de se condenser à température plus basse, sont très différents de ceux qui se posent lors de la réalisation de couches épitaxiales. On peut affirmer que ces problèmes prennent d'autant plus d'importance que le nombre des échantillons est élevé, que les chambres de recuit ont un plus grand volume, que les quantités de gaz en jeu sont importantes, que les températures de recuit sont élevées et que les gaz sont toxiques.

D'autre part, dans d'autre domaines technologiques où il s'agit de réaliser un revêtement des parois d'une partie d'une enceinte, à l'exclusion des parois dans une autre partie, il apparaît des problèmes, lorsque le matériau de revêtement doit être introduit sous forme gazeuse, pour obtenir la séparation nette de la partie où doit être fait le revêtement, de celle par laquelle on introduit le gaz.

Selon l'invention les différents problèmes exposés sont résolus lorsqu'une chambre telle que décrite dans le préambule est caractérisé en ce que qu'elle comprend un bouchon isotherme muni de moyens de déplacement longitudinal pour être positionné entre la zone froide et la zone chaude dans une zone dite intermédiaire, et muni de moyens de couplage avec la(les) tubulure(s) pour transmettre dans une des zones chaude ou froide le(les) gaz introduit(s) par la(les) tubulure(s) pour son(leur) utilisation.

Ainsi, la chambre peut être utilisée comme chambre de recuit telle que décrite dans le revendication 15, et dans ce cas les possibilités de dépôt polluants, en zone froide, sont éliminées, ainsi que les dangers pour le manipulateur, si les gaz sont transmis par les moyens de couplage, vers la zone chaude. La chambre peut par ailleurs être utilisée comme enceinte dans laquelle doit être fait un revêtement des parois, et dans ce cas la région qui doit rester exempte de revêtement est bien séparée par le bouchon de la région qui doit recevoir le revêtement.

L'invention sera décrite plus en détail ci-après en référence avec les figures annexées dont :
- la figure 1 qui représente, en coupe schématique longitudinale, une chambre munie d'un bouchon isotherme, à deux entrées pour des gaz, et munie d'une nacelle porte-échantillon ;
- la figure 2 qui représente, en coupe schématique selon le même axe, le bouchon isotherme seul ;
- la figure 3 qui représente le même bouchon en coupe schématique transversale, selon l'axe A-A de la figure 2.
- la figure 4 qui représente des ensembles de mesures comparées de contamination en particules, sur des plaquettes ayant subi un recuit dans une chambre selon l'invention, et dans une chambre non munie des moyens de l'invention.

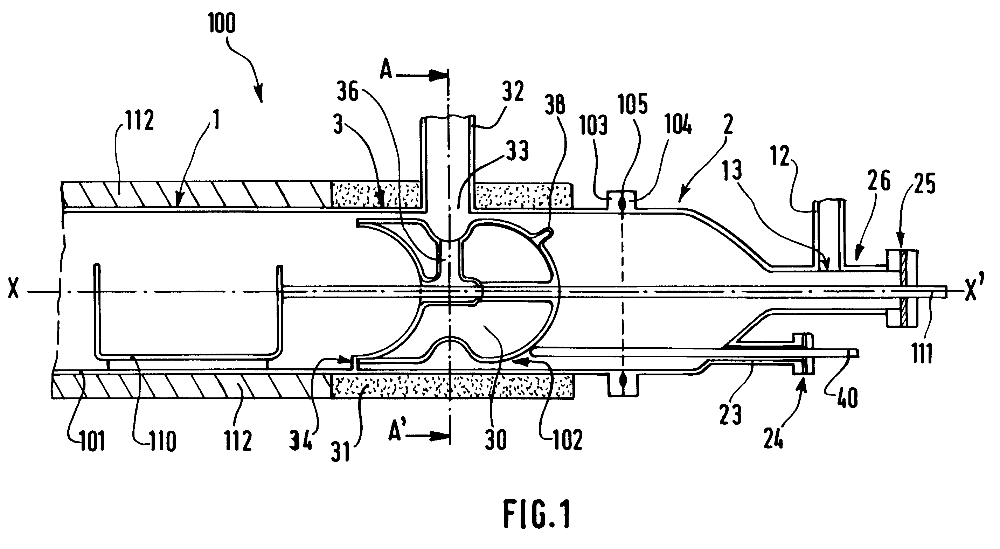

La figure 1 représente en coupe schématique longitudinale une chambre 100 d'un réacteur utilisable dans un procédé de réalisation de dispositifs semiconducteurs, et notamment comme chambre de recuit de dispositifs semiconducteurs du groupe III-V incluant les éléments arsenic (As) et gallium (Ga).

Cette chambre présente une grande dimension mesurée parallèlement à l'axe longitudinal X-X', et de plus faibles dimensions mesurées transversalement.

Dans tout ce qui suit, on considèrera comme très favorable à la mise en oeuvre de l'invention, que la chambre soit cylindrique, c'est-à-dire qu'elle présente une section circulaire, perpendiculairement au plan de la figure 1, de diamètre faible devant la dimension longitudinale selon XX'.

La chambre présente une première partie 1 ou zone chaude, portée à des températures élevées par un système de chauffage 112, qui ne sera pas décrit plus avant, comme étant à la portée de tout homme du métier.

La chambre comprend, considérée le long de l'axe longitudinal XX', une zone 2 dite froide du fait qu'elle n'est pas munie de moyens de chauffage. La zone froide 2 est par exemple à la température ambiante.

Entre la zone 1, et la zone 2, est située la zone intermédiaire 3 où la température est comprise entre celle de la zone chaude et celle de la zone froide.

Favorablement, la zone intermédiaire 3, sera isolée thermiquement pour maintenir sa température assez constante, par exemple à l'aide d'un manchon isolant 31 disposé autour des parois 101 de la chambre, dans cette région 3.

Dans la région intermédiaire 3, est appliquée une tubulure 32 qui débouche dans la paroi 101 de la chambre par l'orifice 33. La tubulure 32, ainsi que l'orifice 33 ont une section de surface S₁.

Dans le procédé de réalisation d'un recuit appliqué à des dispositifs semiconducteurs du groupe III-V, on introduit, par la tubulure 32, un gaz d'arsine (AsH₃) à température ambiante, ou un mélange de gaz d'arsine et d'un gaz neutre par exemple l'hydrogène.

Pour éviter l'altération de l'état de surface des dispositifs semiconducteurs, altération qui se produirait à chaud lors du recuit, ce recuit est pratiqué sous atmosphère d'arsenic (As) qui est obtenu par cracking de l'arsine à la température du recuit, et dans des proportions appropriées.

L'arsine doit donc être amenée par la tubulure d'introduction 32 jusqu'à la zone chaude 1 de la chambre.

D'autre part, l'arsenic formé ne doit pas avoir la possibilité de se déposer sur des parois froides où il se condenserait, formant une couche polluante composée de particules qui viendraient ensuite se déposer sur les échantillons, après le recuit, lorsque ces échantillons sont sortis de la chambre, en passant obligatoirement par une zone froide.

C'est pourquoi durant une opération de recuit incluant la présence d'un gaz polluant tel que l'arsenic obtenu par cracking de l'arsine, un bouchon isotherme 30 est positionné dans la zone intermédiaire 3, pour éviter la condensation des gaz présents dans la zone chaude 1, sur les parois de la chambre dans la zone froide 2.

Le bouchon isotherme 30 se trouve donc positionné dans la région de l'orifice 33 de la tubulure 32, et est placé dans cette position en référence avec une butée 34 sur laquelle vient s'appuyer sa face 35a.

Dans ce cas, pour permettre la transmission du gaz introduit par la tubulure 32 vers la zone chaude 1 de la chambre, le bouchon isotherme 30 est muni d'une ouverture tubulaire 36.

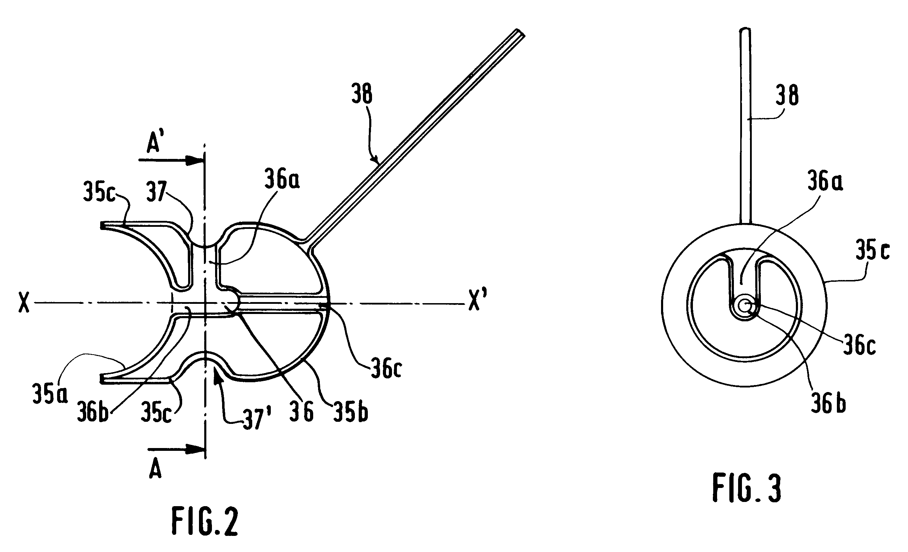

Cette ouverture tubulaire 36, en référence avec la figure 2 qui est une coupe longitudinale du bouchon 30 selon l'axe XX', présente une première partie sensiblement radiale 36a, et une seconde partie 36b sensiblement axiale,c'est-à-dire parallèle à l'axe XX', et en même temps sensiblement centrée dans la section transversale du bouchon, comme montré sur la figure 3 qui est une coupe selon l'axe A-A' de la figure 2.

La position de la partie radiale 36a de l'ouverture tubulaire est prévue pour que, lorsque le bouchon est en position sur la butée 34, l'orifice 37 de la partie radiale 36a à la surface externe du bouchon 30, est en coïncidence avec l'orifice 33 de la tubulure 32 de la chambre.

Ainsi le gaz introduit par la tubulure 32 dans la partie tubulaire 36a parvient dans la zone chaude 1 de la chambre par la partie tubulaire 36b, et les produits du cracking qui a lieu dans la zone chaude 1 ne peuvent polluer la zone froide 2, cette dernière étant isolée par le bouchon isotherme 30.

Cependant, il existe entre les parois externes du bouchon, et les parois internes de la chambre un petit intervalle 102, de surface donnée S₂, nécessaire pour obtenir le coulissement du bouchon jusqu'à la butée 34. Lorsque des gaz réactants très polluants, très toxiques et dangereux, comme l'arsine sont utilisés, on considère que l'intervalle 102 représente une fuite encore trop grande, et que par cette fuite les gaz réactants ont la possibilité d'envahir la zone froide 2 en encore trop grande quantité, malgré la présence du bouchon. C'est pourquoi, on prévoit d'introduire par ailleurs dans la chambre un gaz non réactant, servant de vecteur, par exemple l'hydrogène. Ce gaz doit se propager dans le même sens que le gaz réactant à travers l'intervalle 102, pour avoir la fonction d'anti-retour.

A cet effet, en référence avec la figure 1, se trouve, dans la zone froide 2, une tubulure 12, débouchant dans la chambre par un orifice 13 formé dans les parois 101.

Ainsi le bouchon étant positionné en butée sur le plot 34, les gaz introduits par les tubulures 32 et 12 pénètrent respectivement par les fuites 36 et 102, dans la zone d'utilisation, ici la zone chaude 1.

Pour éviter les turbulences lors de la circulation des gaz et pour que le gaz vecteur introduit par l'intervalle 102 produise une fonction d'anti-retour, la somme des sections S₁ et S₂ des fuites 36 et 102 égale sensiblement la somme des sections des tubulures d'introduction de gaz 32 et 12.

Pour l'introduction des différents éléments nécessaires à la mise en oeuvre de procédés de réalisation de circuits intégrés, tels qu'une nacelle porte-échantillons 110, ou le bouchon 30, la chambre 100 peut être ouverte au niveau des lèvres 103-104. L'étanchéité de la chambre, en l'état où elle est prête pour les opérations de recuit par exemple, est obtenue en rapprochant les lèvres 103-104 autour d'un joint torique 105.

La mise en place du bouchon 30 se fait par coulissement à l'intérieur de la partie froide 2 de la chambre jusqu'au plot de butée 34. Ce coulissement est particulièrement aisé du fait de l'existence de l'intervalle 102, lequel ne présente plus de danger du fait que la propagation d'un gaz à fonction anti-retour est prévue.

Pour la manipulation du bouchon 30, lorsque la chambre est fermée par le système de fermeture 103, 104, 105, une tige 40 couplée avec la face 35b, dite face arrière du bouchon, est prévue. Cette tige est prolongée jusqu'à l'extérieur de la chambre dont elle sort par un bouchon d'étanchéité classique 24.

De préférence, le bouchon d'étanchéité 24 est disposé dans une tubulure 23 parallèle à l'axe longitudinal XX.La tige 40 couplée avec le bouchon 30, la tubulure 23 et le bouchon 30 sont alignés. Le coulissement du bouchon 30 dans la partie froide 2 de la chambre et son positionnement en butée dans la partie intermédiaire 3 sont donc aisés, du fait de l'existence de la tige 40 manipulable de l'extérieur de la chambre.

Pour l'application à la réalisation de dispositifs semiconducteurs, la chambre doit être tenu de telle manière que l'axe longitudinal XX' soit horizontal. En outre, elle doit être munie d'un porte-échantillon, et de préférence, pour l'application à la réalisation de recuits sur des plaquettes échantillons de matériau semiconducteur, ce porte-échantillons sera une nacelle 110 capable de contenir une cinquantaine de plaquettes disposées alors verticalement.

Pour la manipulation de la nacelle 110, après son introduction par le dispositif 103, 104, 105, cette dernière est couplée avec une tige 111. Cette tige est suffisamment longue pour atteindre, lorsque la nacelle est en place dans la zone chaude 1, l'extérieur de la chambre. De plus la tige 111 est parallèle à l'axe longitudinal XX'. A son extrémité non couplée avec la nacelle, la tige 111 sort de la chambre à travers un bouchon d'étanchéité classique 25 à l'extrémité du queusot 26 de la chambre réalisée parallèle à l'axe XX'.

La tubulure d'introduction de gaz vecteur 12 peut être appliquée aux parois longitudinales de ce queusot d'extrémité 26.

Ainsi, au moyen de la tige 111 couplée à la nacelle 110, cette nacelle peut être aisément déplacée dans la chambre lorsque cette dernière est fermée par le dispositif 103, 104, 105.

Dans le cas où une telle nacelle existe, de préférence la tige 40 de mise en position du bouchon 30, n'est pas solidaire de ce dernier alors que la tige 111 couplée à la nacelle 110 est solidaire de cette dernière. Ainsi, pour la mise en place des éléments, on introduit d'abord la nacelle, puis on effectue une poussée sur le bouchon au moyen de la tige 40, qu'on amène ensuite en arrière, sans toutefois l'extraire complètement. Puis, pour sortir les éléments de la chambre, il suffit d'effectuer une traction sur la tige 111 solidaire de la nacelle. Ce mouvement permet la récupération à la fois du bouchon 30 et de la nacelle 110.

Dans une mise en oeuvre préférée de l'invention, pour l'application à l'élaboration de dispositifs semiconducteurs, la chambre 100 sera réalisée en quartz, ainsi que le bouchon 30.

Les tubulures 32 et 12 seront donc également en quartz, ainsi que les tiges 111 et 40.

Pour la réalisation du bouchon 30 en quartz et l'obtention de sa qualité d'isolant thermique, ce bouchon comprendra des parois en quartz 35c parallèles à l'axe XX', et des parois 35a et 35b sensiblement perpendiculaires à l'axe XX'. La paroi 35a est dite "avant", c'est-à-dire tournée vers la nacelle porte-échantillon, et la paroi 35b est dite arrière c'est-à-dire couplée avec le moyen de déplacement du bouchon constitué par la tige 40.

De préférence pour éviter les turbulences des gaz, les parois 35a et 35b du bouchon sont sphériques, la concavité étant tournée vers la nacelle, c'est-à-dire vers l'intérieur de la zone chaude de la chambre, et la convexité vers l'extérieur ou zone froide de la chambre.

Les tubulures 36a, 36b, 36c sont des tuyaux de quartz raccordés aux parois 35c, 35a et 35b respectivement. La propriété d'isolant thermique est alors obtenue en réalisant le vide dans la partie interne du bouchon, qui est dépourvue de matière solide, par exemple au moyen d'un queusot 38 qui est ensuite formé et dont la longueur est réduite pour l'introduction ultérieure du bouchon dans la chambre.

La figure 2 montre que, pour l'application à une chambre en quartz cylindrique, le bouchon isotherme 30 est également cylindrique, de diamètre externe légèrement inférieur au diamètre interne de la chambre pour préserver l'intervalle 102 ayant une surface de section annulaire, S₂, permettant son coulissement dans la chambre.

Pour le raccordement de l'orifice 37 de la tubulure 36a avec la paroi 35c du bouchon, on prévoiera de préférence un petit goulot ou étranglement 37'. Ceci est purement un "tour-de-main" à l'attention de l'homme du métier qui réalise le bouchon en quartz, mais n'apporte rien à l'invention elle-même.

Lorsqu'un recuit est pratiqué dans la chambre pour l'application aux circuits intégrés en matériau III-V incluant l'arsenic et le gallium, et la circulation d'arsine, la température dans la zone chaude 1, pour l'opération de recuit ellemême et le cracking de l'arsine, est de l'ordre de 850°C, c'est-à-dire entre 700° et 1000°C. La température de la zone intermédiaire 3 est alors entre 270 et 330°C, notamment sensiblement 300°C. La zone froide 2 est à la température ambiante. La différence des températures entre zones chaude et froide est donc grande.

Ainsi l'arsenic obtenu par le cracking de l'arsine dans la zone chaude 1, ne se dépose dans aucune des parties de la chambre où la nacelle porte-échantillons 110 peut être amenée à passer lorsqu'elle est extraite de la chambre par l'ouverture du dispositif 103, 104, 105.

Dans une autre forme d'utilisation de l'invention, la chambre peut être une enceinte, par exemple cylindrique, et en n'importe quel matériau, sur les parois d'une zone de laquelle on désire réaliser un dépôt, par exemple par cracking d'un composé gazeux, à l'exclusion des parois d'une autre zone. Dans ce cas, un bouchon tel que décrit précédemment, qui n'est pas nécessairement muni de la fuite 36, mais seulement de l'intervalle 102, est mis en place de manière à occulter l'extrémité de la partie à protéger du dépôt. Puis le gaz est introduit par cette dernière partie, qui restera alors exempte de dépôt et passe par l'intervalle 102 du bouchon vers la seconde zone où il subit le cracking dont les produits se déposent sur les parois. La présente invention trouve ainsi une application directe dans la préparation des creusets en tube de quartz utilisés dans la métallurgie des matériaux II-VI tels que par exemple CdTe, ces creusets nécessitant un revêtement de carbone obtenu par cracking du méthane à haute température.
D'une part le dépôt doit être homogène, et d'autre part la transition doit être abrupte à un endroit précis du creuset afin de ménager une zone absolument dépourvue de dépôt dans laquelle on effectue le scellement final de la composition avant de pratiquer la croissance cristalline du matériau II-VI par la méthode Bridgman.

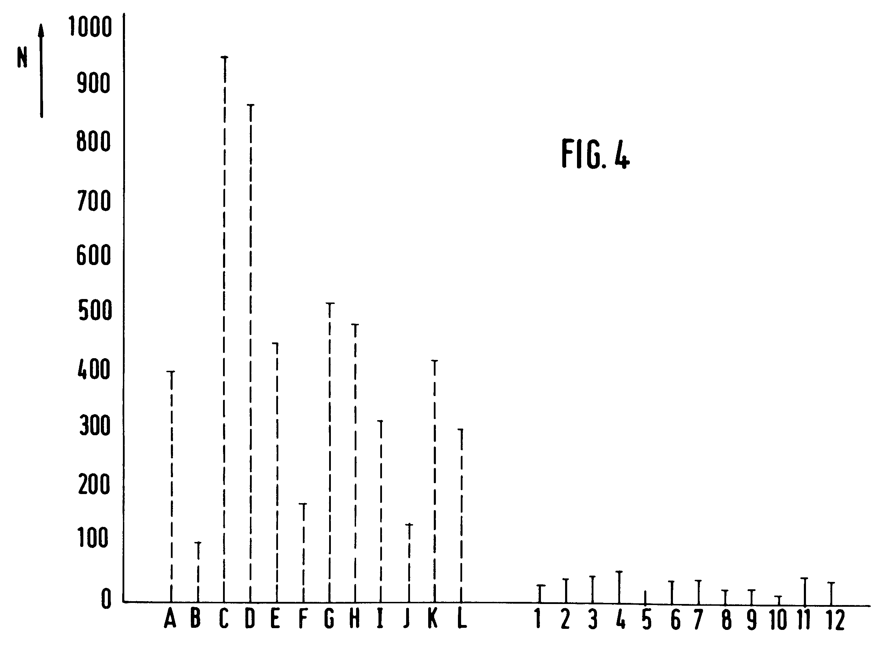

Dans le cas où la chambre selon l'invention est appliquée aux recuits sous arsine, ou tout autre gaz à la fois polluant pour les échantillons et toxique pour les manipulateurs, il n'est plus nécessaire de décontaminer les zones froides des chambres. De plus le nombre des particules polluantes résiduelles trouvées sur les échantillons eux-mêmes est considérablement diminué comme le montre la figure 4. Sur la figure 4 on a rassemblé des mesures du taux de contamination effectuées au moyen d'un analyseur de taux de particules sur des plaquettes de diamètre 2 pouces (environ 5 cm). Chaque mesure correspond à la moyenne pour chaque recuit du nombre N de particules sur un groupe d'environ quarante plaquettes de matériau semiconducteur III-V. Les mesures du nombre N de particules trouvées sur 12 groupes de plaquettes ayant été traitées dans une chambre selon l'invention sont représentées en trait plein (les groupes étant référencés 1 à 12). Les mesures du nombre N de particules trouvées sur les groupes de plaquettes ayant été traitées dans une chambre dépourvue des moyens de l'invention sont représentées en traits discontinus, les groupes étant référencés A à L. On peut considérer que, en moyenne, le taux de contamination est divisé par 10.

La santé du manipulateur est donc mieux protégée. Et le procédé industriel de réalisation de circuits semiconducteurs, étant amputé d'une opération délicate de décontamination, est plus simple, plus rapide et beaucoup moins coûteux.

Des moyens simples peuvent être couplés à la chambre pour éviter la contamination de son extrémité par laquelle sont extraits les gaz. En effet, le problème de la contamination de zone froide, résolu selon l'invention, est principalement difficile à résoudre du fait qu'il faut prévoir dans cette zone un dispositif d'extraction de la nacelle porte-échantillon. A l'autre extrémité de la chambre, le problème se pose différemment, et n'est pas traité ici comme ne faisant pas à proprement parlé partie de la présente invention.

## Revendications

1. Chambre ayant, considérée selon son axe longitudinal, une zone chaude et une zone froide, et ayant au moins une tubulure d'introduction de gaz caractérisée en ce qu'elle comprend un bouchon isotherme muni de moyens de déplacement longitudinal pour être positionné entre la zone froide et la zone chaude dans une zone dite intermédiaire, et muni de moyens de couplage avec la(les) tubulure(s) pour transmettre dans une des zones chaude ou froide le(les) gaz introduit(s) par la(les) tubulure(s) pour son(leur) utilisation.

2. Chambre selon la revendication 1, caractérisée en ce que les moyens de couplage comprennent aussi l'application d'une tubulure d'introduction de gaz à une des parois de la chambre dans une des zones chaude ou froide, opposée à la zone d'utilisation des gaz, et comprennent un intervalle entre les parois externes longitudinales du bouchon et les parois internes de la chambre pour le coulissement du bouchon et pour la transmission du gaz de la zone d'introduction dans l'autre zone, ouzone d'utilisation.

3. Chambre selon la revendication 2, caractérisée en ce que les moyens de couplage comprennent l'application d'une tubulure d'introduction de gaz à une paroi longitudinale de la chambre dans la zone intermédiaire, et une ouverture tubulaire pratiquée dans le bouchon, ayant une partie dite radiale dirigée vers une paroi externe longitudinale du bouchon, et une partie dite axiale dirigée selon l'axe longitudinal de la chambre et du bouchon, vers la zone chaude ou froide d'utilisation des gaz, et en ce que ces moyens comprennent en outre une butée pour la mise en place du bouchon dans la position où la partie radiale de son ouverture tubulaire est alignée avec cette tubulure d'introduction de gaz.

4. Chambre selon la revendication 3, caractérisée en ce que les moyens de déplacement comprennent le coulissement des parois externes longitudinales du bouchon le long des parois internes longitudinales de la chambre sous l'action d'un mouvement de translation longitudinale appliqué à une tige couplée au bouchon, solidaire ou non du bouchon.

5. Chambre selon la revendication 4, caractérisée en ce que les parois externes du bouchon non coulissantes sont sphériques, la convexité étant tournée vers la zone d'introduction de gaz.

6. Chambre selon la revendication 5, caractérisée en ce que le bouchon présente une partie interne dépourvue de matière solide, délimitée par ses parois externes et les parois de ses tubulures, et en ce qu'il est en outre muni d'un queusot pour faire le vide dans cette partie interne avant l'utilisation de la chambre munie du bouchon.

7. Chambre selon la revendication 6, caractérisée en ce que, pour être utilisée par exemple pour le recuit de dispositifs semiconducteurs, elle comprend une nacelle porte-échantillons et des moyens de positionnement de la nacelle dans la zone chaude qui est aussi la zone d'utilisation des gaz.

8. Chambre selon la revendication 7, caractérisée en ce que les moyens de positionnement de la nacelle consiste en une tige coulissant à travers le bouchon isotherme, parallèlement à l'axe longitudinal de la chambre et du bouchon, dans une ouverture tubulaire pratiquée dans le bouchon.

9. Chambre selon la revendication 8, caractérisée en ce que la partie axiale de l'ouverture tubulaire pratiquée dans le bouchon pour l'introduction de gaz coïncide avec une partie de l'ouverture tubulaire pratiquée dans le bouchon pour le coulissement de la tige de positionnement de la nacelle.

10. Chambre selon la revendication 9, caractérisée en ce qu'elle est en quartz.

11. Chambre selon la revendication 10, caractérisée en ce que le bouchon est en quartz.

12. Chambre selon l'une des revendications 10 ou 11, caractérisée en ce qu'elle est cylindrique, de même que les parois externes coulissantes du bouchon.

13. Chambre selon l'une des revendications 9 à 12 caractérisée en ce que la somme des aires des sections des tubulures d'introduction de gaz pratiquées sur les parois de la chambre égale la somme des aires de la section de l'intervalle entre parois externes et internes du bouchon et de la chambre respectivement, et de la section de l'ouverture tubulaire pratiquée dans le bouchon pour la transmission de gaz.

14. Chambre selon la revendication 13, caractérisée en ce qu'elle comprend une partie ouvrante, assujettissable par un joint torique, pour introduire la nacelle et le bouchon, disposée dans la zone froide, et en ce qu'elle comprend des moyens d'extraction des gaz disposés de l'autre côté de la zone chaude.

15. Procédé en phase vapeur de réalisation de dispositifs semiconducteurs du groupe III-V ou II-VI incluant une étape de decomposition et de recuit, caractérisé en ce que cette étape de recuit est mise en oeuvre dans une chambre selon l'une des revendications 7 à 14.

16. Procédé selon la revendication 15, caractérisé en ce que la température dans la zone chaude, dite zone de recuit est dans la fourchette 700 à 1000°C, la température dans la zone intermédiaire est dans la fourchette 270° à 330°C et la température dans la zone froide est inférieure à celle de la zone intermédiaire, par exemple est à la température ambiante.

17. Procédé selon la revendication 16, caractérisé en ce que les échantillons semiconducteurs sont en un matériau III-V incluant l'arsenic et le gallium.

18. Procédé selon la revendication 17, caractérisé en ce qu'au moins un gaz introduit par la tubulure de la chambre disposée dans la zone intermédiaire est l'arsine, et au moins un gaz introduit par la tubulure de la chambre disposée dans la zone froide est l'hydrogène utilisé comme gaz vecteur, l'arsine subissant un cracking dans la zone chaude pour fournir de l'arsenic.

## Claims

1. A chamber which has along its longitudinal axis a hot zone and a cold zone and which has at least one gas inlet tube, characterized in that it comprises a heat-insulating plug provided with longitudinal displacement means for being positioned between the cold zone and the hot zone in an intermediate zone, and provided with coupling means to the tube(s) for transmitting into one of the zones, hot or cold, the gas(es) introduced through the tube(s) so as to be used.

2. A chamber as claimed in Claim 1, characterized in that the coupling means also comprise the application of a gas inlet tube to one of the walls of the chamber in one of the zones, hot or cold, opposed to the zone in which the gas is utilized, and comprise an interspacing between the longitudinal outer walls of the plug and the inner walls of the chamber for allowing the plug to slide and for allowing gas to pass from the inlet zone to the other zone, *i.e.* the utilization zone.

3. A chamber as claimed in Claim 2, characterized in that the coupling means comprise the application of a gas inlet tube to a longitudinal wall of the chamber in the intermediate zone and of a tubular duct in the plug, this duct having a radial portion which is directed towards a longitudinal outer wall of the plug and an axial portion which is directed along the longitudinal axis of the chamber and the plug towards the hot or cold zone in which the gas is used, and in that said means comprise in addition a stop for locating the plug in the position in which the radial portion of its tubular duct is in line with said gas inlet tube.

4. A chamber as claimed in Claim 3, characterized in that the displacement means comprise the sliding possibility of the longitudinal outer walls of the plug along the longitudinal inner walls of the chamber under the action of a longitudinal translatory movement applied to a rod coupled to the plug, which rod may or may not be integral with the plug.

5. A chamber as claimed in Claim 4, characterized in that the non-sliding outer walls of the plug are spherical with the convex side facing towards the gas inlet zone.

6. A chamber as claimed in Claim 5, characterized in that the plug has an internal portion devoid of solid material and limited by its outer walls and the walls of its ducts, and in that it is in addition provided with an exhaust tube for evacuating said internal portion before the chamber provided with the plug is used.

7. A chamber as claimed in Claim 6, characterized in that, for the purpose of being used for, for example, the heat treatment of semiconductor devices, it comprises a sample support and positioning means for said support in the hot zone which then also is the zone in which the gas is utilized.

8. A chamber as claimed in Claim 7, characterized in that the positioning means for the support comprise a rod which slides through the heat-insulating plug, parallel to the longitudinal axis of the chamber and the plug, in a tubular opening provided in the plug.

9. A chamber as claimed in Claim 8, characterized in that the axial portion of the tubular duct provided in the plug for the introduction of gas coincides with a portion of the tubular opening provided in the plug for allowing the positioning rod for the support to slide.

10. A chamber as claimed in Claim 9, characterized in that it is made of quartz.

11. A chamber as claimed in Claim 10, characterized in that the plug is made of quartz.

12. A chamber as claimed in Claim 10 or 11, characterized in that it is cylindrical, as are the sliding outer walls of the plug.

13. A chamber as claimed in any one of the Claims 9 to 12, characterized in that the sum of the cross-sectional areas of the gas inlet tubes provided in the walls of the chamber is equal to the sum of the cross-sectional areas of the interspacing between the outer walls of the plug and the inner walls of the chamber and of the tubular duct provided in the plug for the transmission of gas.

14. A chamber as claimed in Claim 13, characterized in that it comprises an opening section operable by an annular seal for the introduction of the sample support and the plug, arranged in the cold zone, and in that it comprises gas extraction means at the other side of the hot zone.

15. A method of manufacturing semiconductor devices of group III-IV or II-VI in the vapour phase, which method comprises a step of decomposition and a heat treatment, characterized in that said heat treatment step is carried out in a chamber as claimed in any one of the Claims 7 to 14.

16. A method as claimed in Claim 15, characterized in that the temperature in the hot zone or heat treatment zone is in the 700 to 1000°C range, the temperature in the intermediate zone is in the 270 to 330°C range, and the temperature in the cold zone is lower than that of the intermediate zone, for example, ambient temperature.

17. A method as claimed in Claim 16, characterized in that the semiconductor samples are made of a III-V material comprising arsenic and gallium.

18. A method as claimed in Claim 17, characterized in that at least one gas introduced through the chamber tube arranged in the intermediate zone is arsine and at least one gas introduced through the chamber tube arranged in the cold zone is hydrogen, which is used as a vector gas, the arsine being subjected to a cracking operation in the hot zone so as to provide arsenic.

## Patentansprüche

1. Kammer mit einer Warmzone und einer Kaltzone auf seiner Längsachse, und wenigstens ein Gaseinlaßrohr, dadurch gekennzeichnet, daß sie einen Wärmeisolierpfropfen enthält, der mit Mitteln zum Verlagern in der Längsrichtung zum Positionieren zwischen der Kaltzone und der Warmzone in einer Zwischenzone und Koppelmittel mit dem Rohr (den Rohren) zum Übertragen des (der) Gases (Gase) von einer der Warm- oder Kaltzonen durch das (die) Rohr(e) für ihre Verwendung(en) enthält.

2. Kammer nach Anspruch 1, dadurch gekennzeichnet, daß die Koppelmittel ebenfalls die Anwendung eines Gaseinlaßrohrs in einer der Kammerwände in einer der Warm- oder Kaltzonen enthalten, und zwischen den externen Längswänden des Pfropfens und den inneren Wänden der Kammer für die Gleitlagerung des Pfropfens und für die Strömung des Gases aus der Einlaßzone in die andere Zone, oder auch Nutzzone, einen Zwischenraum enthält.

3. Kammer nach Anspruch 2, dadurch gekennzeichnet, daß die Koppelmittel die Anwendung eines Gaseinlaßrohrs in einer Längswand der Kammer in der Zwischenzone, und eine im Pfropfen angebrachte zylinderförmige Öffnung mit einem radialen auf eine externe Längswand des Pfropfens gerichteten Anteil, in einer der Warm- oder Kaltzonen enthalten, und einen axialen auf der Längsachse der Kammer und des Pfropfens auf die Warm- oder Kaltzone für den Gasgebrauch gerichteten Anteil enthält, und daß diese Mittel außerdem einen Anschlag zum Positionieren des Pfropfens an der Stelle enthalten, an der der radiale Anteil ihrer zylinderförmigen Öffnung mit diesem Gaseinlaßrohr fluchtet.

4. Kammer nach Anspruch 3, dadurch gekennzeichnet, daß die Verlagerungsmittel die Gleitlagerung der externen Längswänden des Pfropfens entlang der inneren Längswänden der Kammer unter der Einwirkung einer Längstranslationsbewegung auf einen mit dem Pfropfen gekoppelten Schaft enthalten, möglicherweise als Einheit mit dem Pfropfen.

5. Kammer nach Anspruch 4, dadurch gekennzeichnet, daß die nichtgleitenden externen Wände des Pfropfens sphärisch sind, wobei die Konvexität der Gaseinlaßzone zugewandt ist.

6. Kammer nach Anspruch 5, dadurch gekennzeichnet, daß der Pfropfen einen inneren Anteil ohne festes Material enthält, der durch seine externen Wände und die Wände seiner Rohre begrenzt werden, und daß er außerdem einen Pumpstengel zum Evakuieren dieses inneren Anteils vor der Benutzung der Kammer mit dem Pfropfen enthält.

7. Kammer nach Anspruch 6, dadurch gekennzeichnet, daß sie beispielsweise zum Glühen von Halbleiteranordnungen ein Probenträgerschiffchen sowie Positioniermittel für das Schiffchen in der Warmzone enthält, die ebenfalls die Nutzzone der Gase ist.

8. Kammer nach Anspruch 7, dadurch gekennzeichnet, daß die Positioniermittel für das Schiffchen aus einem Gleitstift durch den isothermischen Pfropfen parallel zur Längsachse der Kammer und des Pfropfens in einer im Pfropfen angebrachten zylinderförmigen Öffnung besteht.

9. Kammer nach Anspruch 8, dadurch gekennzeichnet, daß der axiale Anteil der im Pfropfen angebrachten zylinderförmigen Öffnung für den Gaseinlaß mit einem Anteil der im Pfropfen angebrachten zylinderförmigen Öffnung zum Gleitlagern des Positionierstifts für das Schiffchen zusammenfällt.

10. Kammer nach Anspruch 9, dadurch gekennzeichnet, daß sie aus Quarz besteht.

11. Kammer nach Anspruch 10, dadurch gekennzeichnet, daß der Pfropfen aus Quarz besteht.

12. Kammer nach einem der Ansprüche 10 oder 11, dadurch gekennzeichnet, daß sie zylindrisch ist sowie auch sind es die externen Gleitwände des Pfropfens.

13. Kammer nach einem der Ansprüche 9 bis 12, dadurch gekennzeichnet, daß die Summe der Gebiete der Abschnitte der Gaseinlaßrohre in den Wänden der Kammer gleich der Summe der Gebiete des Abschnitts des Zwischenraums zwischen externen und inneren Wänden des Pfropfens bzw. der Kammer und des Abschnitts der im Pfropfen angebrachten rohrförmigen Öffnung für den Gasdurchfluß ist.

14. Kammer nach Anspruch 13, dadurch gekennzeichnet, daß sie zum Einführen des Schiffchens und des Pfropfens in der Kaltzone einen mittels eines Ringgelenks aufsteuerbaren Anteil zum Einführen des Schiffchens und des Pfropfens enthält, und daß sie an der anderen Seite der Warmzone Gasextraktionsmittel enthält.

15. Dampfphasenverfahren zum Herstellen von Halbleiteranordnungen der Gruppe III-V oder II-VI mit einem Zersetzungs- und Glühschritt, dadurch gekennzeichnet, daß dieser Glühschritt in einer Kammer nach einem der Ansprüche 7 bis 14 erfolgt.

16. Verfahren nach Anspruch 15, dadurch gekennzeichnet, daß die Temperatur in der Warmzone, d.h. der Glühzone, in der Gabel 700 bis 1000°C beträgt, die Temperatur in der Zwischenzone in der Gabel 270 bis 330°C beträgt und die Temperatur in der Kaltzone niedriger ist als die der Zwischenzone und beispielsweise auf der Umgebungstemperatur.

17. Verfahren nach Anspruch 16, dadurch gekennzeichnet, daß die Halbleiterproben aus einem Werkstoff III-V mit Arsen und Gallium bestehen.

18. Verfahren nach Anspruch 17, dadurch gekennzeichnet, daß wenigstens ein durch das Rohr der Kammer in der Zwischenzone eingeführtes Gas Arsin ist, und wenigstens ein durch das Rohr der Kammer in der Kaltzone eingeführtes Gas als Vektorgas benutzter Wasserstoff ist, wobei das Arsin ein Cracking-Verfahren in der Warmzone erfährt, um das Arsen zu erhalten.
